# EUROPEAN PATENT APPLICATION

(11) **EP 2 733 499 A1**
(43) Date of publication of application: **21.05.2014**
(21) Application number: 12007778.9
(22) Date of filing: 16.11.2012
(51) Int. Cl.: G01R 33/34

(54) **MRI coil arrangement and method of manufacturing thereof**

(71) Applicant: Max-Planck-Gesellschaft zur Förderung der Wissenschaften e.V., 80539 München (DE)
(72) Inventor: Rivera, Debra, Santa Monica, CA 90402 (US); Müller, Roland, 04299 Leipzig (DE)
(74) Representative: Hertz, Oliver

(57) **Abstract**

An RF coil arrangement (100), being adapted for magnetic resonance imaging of a sample (1) in a sample space (2) under investigation, comprises a plurality of carrier boards (10, 20, 30) being made of printed circuit boards and carrying a plurality of coil segments (11), wherein the carrier boards (10, 20, 30) are mechanically connected with each other so that a three-dimensional arrangement of coil segments (11) is formed. Furthermore, a method of manufacturing the coil arrangement and a magnetic resonance imaging apparatus including the coil arrangement are described.

## Description

The present invention relates to a coil arrangement for magnetic resonance imaging, comprising a plurality of carrier boards made of printed circuit boards, and to a method of manufacturing thereof. Applications of the invention are available in the field of magnetic resonance imaging.

Magnetic resonance imaging (MRI) apparatuses include radio frequency (RF) coils (also called: antennas) for influencing the alignment of nuclear spins in a static magnetic field and for sensing electro-magnetic fields emitted by relaxation processes of nuclear spins. Surface and volume coils are available, which differ in terms of the shape of the coil sensitivity. Although planar circuits for surface coils can be routinely batch fabricated with high precision and low cost, three dimensional circuit fabrication remains a challenge. Three-dimensional antenna designs that are fractal or multilevel (e.g., US patents: 7,123,208 and 7,482,994), prove difficult to mass-produce.

Conventionally, RF coils for magnetic resonance imaging are made of hand-formed wire, hand-laid copper tapes, flexible printed circuits adhered by hand to cylindrical substrates, or can be made by etched or printed rigid circuit boards assembled by hand. All methods require a high degree of skill to fabricate or align the circuits to specifications that are reproducible and consistent with layouts defined in simulation. Such methods are time consuming, and leave much room for error. In the field of micro-fabrication, the jump from planar structures to cylindrical substrates suffers a similar trade-off. While photolithography methods inherently translate more easily to flat surfaces, cylindrical substrate microfabrication is costly, less precise, and is not amenable to batch fabrication.

A known method for the fabrication of three-dimensional circuits is the connection of multiple rigid board regions by bendable regions that can act as hinges (US patents: 5,008,496 and 5,206,463). However possible configurations enabled through these technologies are restricted. As another example of this approach, US 6 198 962 B1 uses a printed circuit board (PCB) as the rigid board. For providing a volume coil, additional conductors are connected with the printed circuit board. As a disadvantage, the coil of US 6 198 962 B1 requires an additional support structure carrying the PCB and the additional conductors. Furthermore, the precision of positioning the conductors and tuning the coil are essentially restricted, and not compatible with batch fabrication.

Due to the restricted coil layout precision, the following general disadvantages result from the conventional techniques. Especially at high field (3 T and above), computer simulation is used to predict the degree and location of small regions of elevated temperature deposition. The more the coil layout differs from simulation, the less accurate the simulation. Additionally, common-mode currents induced on the outer conductors of cable shields are also a risk for inducing burns. Asymmetries in elements or across an array lead to unequal stray capacitances, and therefore voltage differences that can drive common-mode currents.

Objectives of the invention are to provide an improved coil arrangement for magnetic resonance imaging and/or an improved method of manufacturing thereof, being capable of avoiding disadvantages of conventional techniques. In particular, the coil arrangement should be improved in terms of tuning precision, fine-tuning capability, and/or high throughput and inexpensive processing. Furthermore, the manufacturing method should be improved in terms of precision, reproducibility and reducing complexity. Furthermore, it is an objective of the invention to provide an improved MRI apparatus including at least one three-dimensional coil arrangement, being capable of avoiding disadvantages of conventional techniques.

These objectives are solved with a coil arrangement, a manufacturing method and/or an MRI apparatus comprising the features of the independent claims. Preferred embodiments of the invention are defined in the dependent claims.

According to a first general aspect of the invention, a coil arrangement (coil array), in particular for magnetic resonance imaging, is provided, which comprises a plurality of carrier boards carrying coil segments, wherein the carrier boards are made of printed circuit boards (PCBs). According to the invention, the carrier boards are mechanically connected with each other, so that a three-dimensional arrangement of coil segments is created, and the coil segments provide a radio frequency coil. The carrier boards being directly connected with each other, preferably with a straight mechanical contact, are adapted to be arranged adjacent to a sample space to be investigated.

The terms "carrier board" refers to a PCB which carries at least one of the coil segments and optionally additional electronic components, like capacitors or other circuitry components. The PCB preferably is a plane board made of a plastic material, like a composite of glass fibers and resin, and carrying a structured metal layer on one or both surfaces thereof. The metal layer, e.g. made of copper, is structured so that the coil segments are formed. The coil segments are electrically conducting strip or wire sections on at least one of the PCB surfaces. Depending on the function of the coil arrangement, some of the PCBs or sections thereof may carry wire sections only. Furthermore, the coil arrangement can be provided with additional PCBs without any coil segment, for mechanical stability purposes or for providing a connector component. Generally, the carrier boards may have equal or different design properties. The carrier boards have different orientations in space relative to each other, i.e. at least some of the carrier boards are non-parallel relative to each other. In the present specification, the largest carrier board(s) is (are) called "main board(s)", while other carrier boards are called "secondary boards". The secondary boards are fixed on the main board in a projecting manner.

As a main advantage, the invention provides the coil arrangement with high precision and reproducibility of structure size and alignment in three dimensions. The inventors have found that coil arrangements made of PCBs can be designed with increased stability and an improved adaptation of the radio frequency characteristics to theoretical simulation values to be obtained. The adaptation of the coil arrangement to a particular sample to be imaged, like e.g. to a particular patient in medical imaging, is essentially facilitated. Due to the direct connections of the carrier boards with each other, the stability of the coil arrangement is obtained without additional supporting structures.

The invention, as it relates to the fabrication of RF coils for MR imaging, is of particular relevance for patient/subject safety. Differences between the coil layout and a simulation can be minimised. Especially at high field (3 T and above), risks for inducing burns and unequal stray capacitances can be reduced.

According to a second general aspect of the invention, a magnetic resonance imaging apparatus (MRI apparatus) is proposed, which includes the coil arrangement according to the above first aspect of the invention. With a preferred example, at least one of the carrier boards is arranged perpendicular to a direction of the static magnetic field of the MRI apparatus, while other carrier boards are aligned parallel to the direction of the static magnetic field. Alternatively, a box shaped coil arrangement, in particular a cube shaped coil arrangement is possible, wherein one of the diagonals is aligned parallel to the direction of the static magnetic field. With this embodiments, all PCBs can be inclined relative to the direction of the static magnetic field.

The MRI apparatus of the invention has advantages in terms of an easy application of the coil arrangement and an increased reproducibility of controlling the coil arrangement.

According to a third general aspect of the invention, a method of manufacturing the coil arrangement according to the above first aspect is provided. The invention provides a method, in which multiple rigid circuit board elements with connectors, such as e.g. a slit or tab (or more conventional board connectors), to enable planar printed circuit boards to be assembled into three-dimensional structures. The manufacturing method of the invention is characterized by the steps of providing the carrier boards carrying the coil segments and mechanically connecting the carrier boards so that the three-dimensional arrangement of coil segments is created. As an essential advantage of the manufacturing method, the step of providing the carrier boards includes a design of the coil segments and possibly further electronic components on the PCBs by available software-based design and processing techniques. The coil segments and possibly the further electronic components can be made with precision in sub-mm range. Due to the capability of the PCBs to be connected with high precision, the manufacturing method allows the production of the coil arrangement with high throughput and inexpensive processing.

In addition to enhancing safety aspects, the proposed method can be used for fabrication, for example of multi-row overlapped coil array geometries. The optimal amount of overlap can be experimentally determined, and uniform across the array with near sub-millimeter precision. The present invention allows alignment holes (i.e. for threaded spacers), or machined spacers to find and optimize the overlap of the arrays to cancel out the mutual inductance.

As a further advantage of the invention, the coil arrangement provides a flexibility in terms of creating different types of coils or antennas. As preferred examples, the PCBs can be arranged such that the coil segments form a Helmholtz coil arrangement, surface coil arrays or a birdcage coil arrangement. The PCBs providing the carrier boards can be easily adapted to the particular application of the coil arrangement.

With a preferred example of the invention, the coil arrangement comprises two main boards, which are arranged with a mutual distance. The two main boards are arranged on opposite sides of the sample space to be investigated. With this embodiment, further carrier boards (secondary boards) are connected between the main boards. The secondary boards extend along the distance between the main boards on different sides of the sample space to be investigated. With the carrier boards, the sample space preferably is enclosed in all three dimensions. The embodiment with the two main boards connected via the secondary boards has particular advantages in terms of creating a homogeneous radio frequency characteristic in the sample space. Simultaneously, the carrier boards provide a high mechanical stability. The PCBs stabilize each other so that field deformations during the application of the coil arrangement are avoided.

According to a further preferred embodiment of the invention, at least one of the carrier boards is provided with a recess (access opening). The recess is a through-hole, typically in a central section of the respective carrier board, which allows the introduction of a sample into the sample space between the carrier boards and/or a manipulation of the sample in the sample space. According to particularly preferred embodiments, the carrier board having the recess is shaped as a ring, like e.g. a circular ring, or a ring-like structure with an elliptical shape or with a polygon shape.

Preferably, a cover board is provided which carries coil segments and which is removably arranged across the recess. Advantageously, the cover board keeps the electrical function of the respective carrier board in the assembled state of the coil arrangement. When the recess is closed by the cover board, advantages for shaping the radio frequency field in the sample space are obtained. The cover board which is considered as a board section of the respective carrier board is another PCB carry further coil segments, which is removably arranged on the respective carrier board. During the use of the coil arrangement, the recess is closed by the cover board, wherein the coil segments of the cover board are electrically connected with the coil segments of the carrier board. Advantageously, with the combination of the main board and the cover board closing the recess, any adverse effects on the field shaping are avoided, while an access to the sample space is kept.

According to a further modification of the invention, at least one of the carrier boards can be provided with at least one through-hole, like e.g. at least one slit (slot) or circular hole, for venting and/or stray capacitance reduction purposes. Preferably, a plurality of through-holes is provided. The through-holes are arranged between coil segments on the PCBs, e.g. between ends of coil segments facing to each other and/or between adjacent parallel coil segments. They provide the dielectric properties of air, so that stray capacitances are reduced and the quality of the radio frequency field shaping is improved. Additionally, fresh air can be fed into the sample space, so that the conditions during magnetic resonance imaging, in particular for a patient, can be improved.

According to another modification of the invention, at least one of the carrier boards comprises at least two board sections made of printed circuit boards connected with each other. In other words, the carrier board can consist of two or more sub-boards arranged in a common plane. The construction with two board sections provides advantages for the flexibility in designing the coil.

According to the invention, the carrier boards are mechanically connected to each other. Preferably, the PCBs are provided with connectors through which the carrier boards are connected. Preferably, the connectors are integral parts of the PCBs or components (in particular non-magnetic components, e. g. made of brass or plastics) fixed to the PCBs, so that the PCBs can be connected to each other by rigid and stiff connections. Advantageously, there are multiple options of the connector design. According to a first variant, the connectors comprise plane to edge connectors, wherein an edge of a first PCB is connected to a plane surface section of the other PCB. According to a second variant, edge to edge connectors can be provided, wherein an edge of the first PCB is connected to the edge of another PCB. Preferred examples of connectors are pairs of slits and tabs provided at the PCBs facing to each other.

According to a particular preferred embodiment of the invention, the connectors provide a force fit connection of the PCBs. The connectors are shaped such that a fixed connection is provided without additional measures, like e.g. additional supporting components or adhesives. Alternatively, the connectors can be adapted for providing a shape fit connection. In this case, preferably an adhesive or solder is used for stabilizing the connection of the carrier boards.

According to a particularly preferred embodiment of the invention, the coil arrangement is a self-supporting structure. Advantageously, the carrier boards are connected without an additional support structure.

According to the invention, each of the carrier boards has at least one coil segment on at least one surface thereof. The plurality of the coil segments provide the coil arrangement of the MRI coil or antenna. Depending on the function of the coil arrangement, the coil segments can be electrically connected with each other. According to this embodiment of the invention, at least one electrical connection is provided between the carrier boards. As needed, solder pads or holes for conductive bridges such as bent conductive tabs, wires, or conductive screws, can be used to convey signal between adjacent boards. Preferably, the electrical connection is implemented using at least one strip conductor carried by the connected boards. Additionally or alternatively, the electrical connection can be implemented by the use of non-magnetic screws. As an example, brass screws can be used for connecting the carrier boards with each other.

Further details and advantages of the invention are described in the following with reference to the attached drawings, which show in:
- Figure 1:: a perspective view of a coil arrangement according to a first embodiment of the invention;
- Figure 2:: plan views of the PCBs used for manufacturing the coil arrangement of Figure 1;
- Figure 3:: schematic illustrations of connectors and through-holes, which can be provided in a coil arrangement according to the invention;
- Figure 4:: schematic illustrations of stray capacitance reducing through-holes, which can be provided in a coil arrangement according to the invention;
- Figure 5:: a perspective view of a coil arrangement according to a second embodiment of the invention;
- Figure 6:: a plan view of one of the main boards of the coil arrangement according to Figure 5;
- Figure 7:: a plan view of one of the secondary boards of the coil arrangement according to Figure 5;
- Figure 8:: a schematic illustration of electrical connections of PCBs according to the invention;
- Figure 9:: schematic illustrations of segmenting a PCB in a coil arrangement according to the invention;
- Figure 10:: schematic illustrations of carrier boards according to a third embodiment of the invention; and
- Figure 11:: a schematic illustration of an MRI apparatus according to the invention.

Preferred embodiments of the invention are described in the following with particular reference to the design of the coil arrangement made of PCBs. Details of the coil segment design, the tuning of the coil arrangement, the MRI apparatus including the coil arrangement and the operation thereof are not described as far as they are known from conventional MRI techniques. In particular, the coil segments can be designed in dependency on the radio frequency field characteristics to be obtained with the coil arrangement. Furthermore, exemplary reference is made here to coil arrangements for Helmholtz coils or surface coil arrays. The application of the invention is not restricted to the described coils, but rather possible with modified coil geometries, e.g. Birdcage coils. Furthermore, the drawings represent schematic illustrations of the carrier boards showing in particular the coil segments. Additional components, like capacitors or circuitries can be provided, which are not shown in the figures.

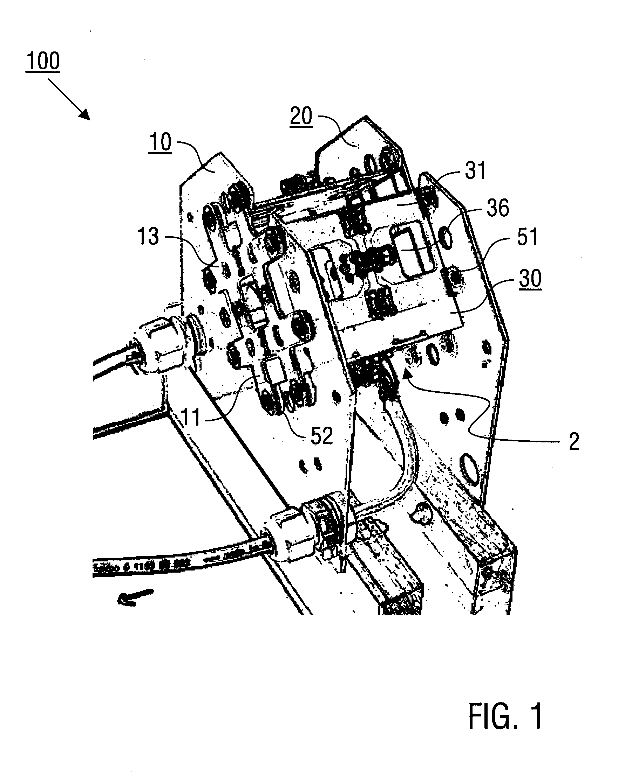

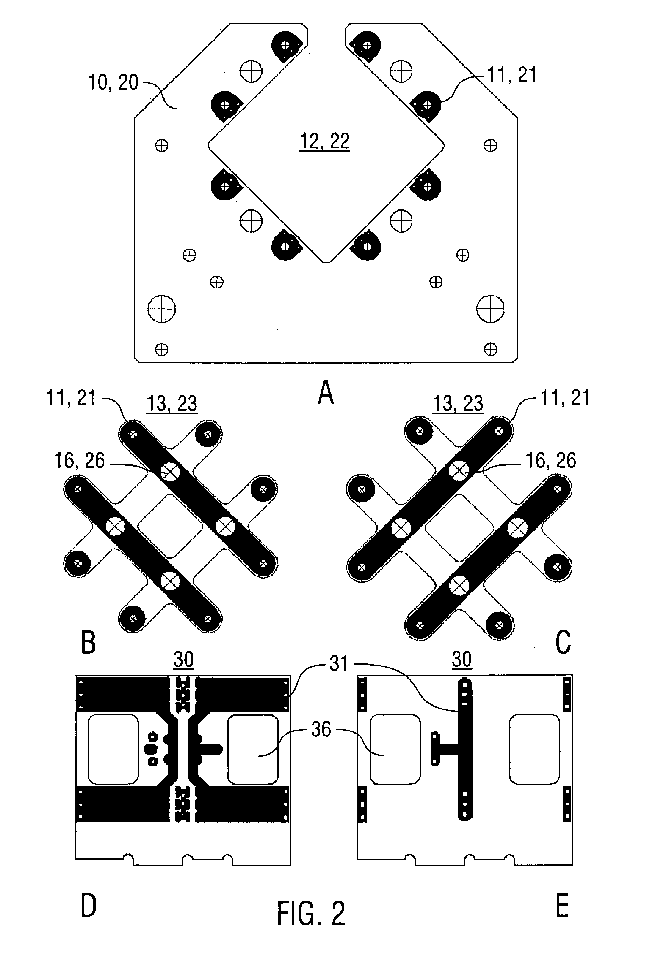

Figures 1 and 2 illustrate a first embodiment of a coil arrangement 100 according to the invention. With this embodiment, two perpendicular Helmholtz coil pairs are combined to obtain a quadrature transmit and receive (or: transceiver) coil. The coil arrangement 100 comprises four plane carrier boards with two main boards 10, 20, and two secondary boards 30 enclosing a sample space 2. The main boards 10, 20 are connected via the secondary boards 30. Each of the carrier boards is made of a standard PCB material, e.g. plane plates of a glass fibre / resin composition having a thickness of e.g. 2,2 mm. Coil segments 11, 21, 31 are provided on the carrier boards or parts thereof by conventional techniques of processing PCBs. The coil segments 11, 21, 31 comprise Cu having a thickness of e.g. 35 µm.

Both main boards 10, 20 have an identical design. Each of the main boards 10, 20 (see Figure 2A) is a plane board having a central recess 12, 22. The recesses 12, 22 of the main boards 10, 20 are covered by cover boards 13, 23, resp.. Both cover boards 13, 23 have an identical design as well. The opposite surfaces of the cover boards 13, 23 are illustrated in Figures 2B and 2C. The cover boards 13, 23 carry coil segments 11, 21, which comprise strips of metal layers, in particular Cu layers having a width of e.g. 10 mm and being created by structuring the respective PCB. The coil segments 11, 21 on one of the surfaces intersect the coil segments 11, 21 on the opposite surface. At the intersections, bores 16, 26 are provided for reducing stray capacitances between the coil segments 11, 21 on the opposite surfaces. Accordingly, dielectric lost and parasitic coupling can be reduced. Furthermore, each of the cover boards 13, 23 includes a central through-hole, which is arranged for venting the sample space 2.

Both surfaces of the secondary boards 30 are shown in Figures 2D, 2E. The secondary boards 30 carry coil segments 31 and further electronic components for tuning purposes, like e.g. capacitors (not shown). Furthermore, the secondary boards 30 have through-holes 36 for venting the sample space.

In the assembled state (see Figure 1), the secondary boards 30 are connected with a mutual perpendicular orientation between the main boards 10, 20. The connection is obtained using angled strip conductors 51 on the secondary boards 30 and brass screws 52 connecting the cover boards 13, 23 through the plates of the main boards 10, 20 with the strip conductors 51. Accordingly, the combination of the strip conductors 51 and brass screws 52 provide both the mechanical and electrical connection of the PCBs. With the illustrated design of the coil segments 11 and 31, loop-shaped, quadratic Helmholtz coils are created.

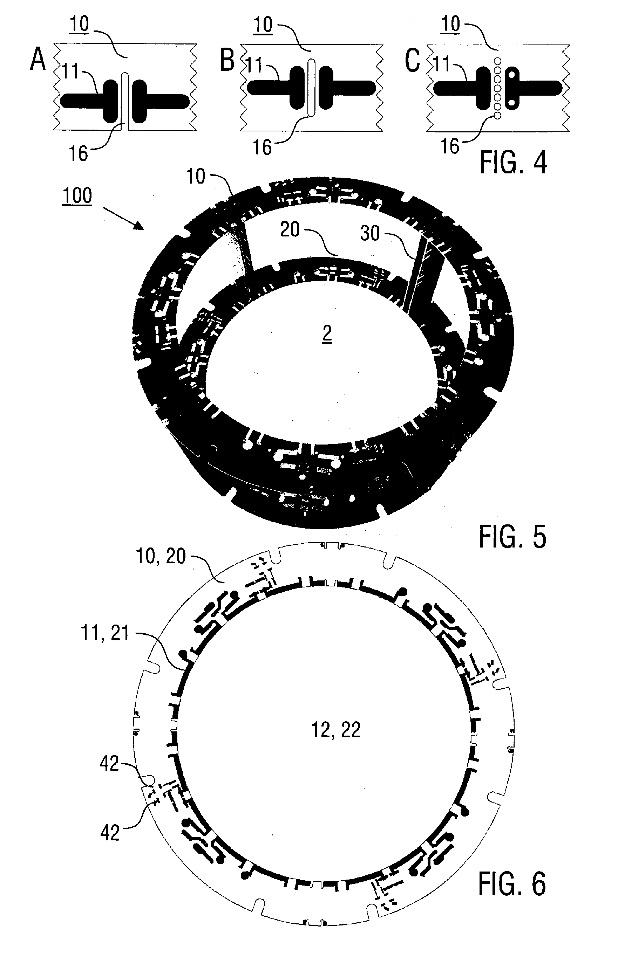

For manufacturing the coil arrangement of Figure 1, the carrier boards 10, 20 and 30 with the coil segments 11, 21 and 31 are prepared. On the basis of a simulation of an rf field to be obtained in the sample space, coil data are generated including the size, shape and position of the coil segments. According to the coil data, the design of PCBs is planned using available software. The number, shape and size of required PCBs is selected. Raw PCBs are formed in particular with the connectors and components for electrical connections. Subsequently, the raw PCBs are processed with conventional methods, so that the coil segments are formed on the PCB surfaces, and additional electronic components are mounted on the PCBs. Finally, the carrier boards 10, 20 and 30 are connected with each other so that the three-dimensional arrangement of coil segments as shown e.g. in Figures 1 or 5 (see below) is created, and the electrical connections between coil segments on different boards are formed.

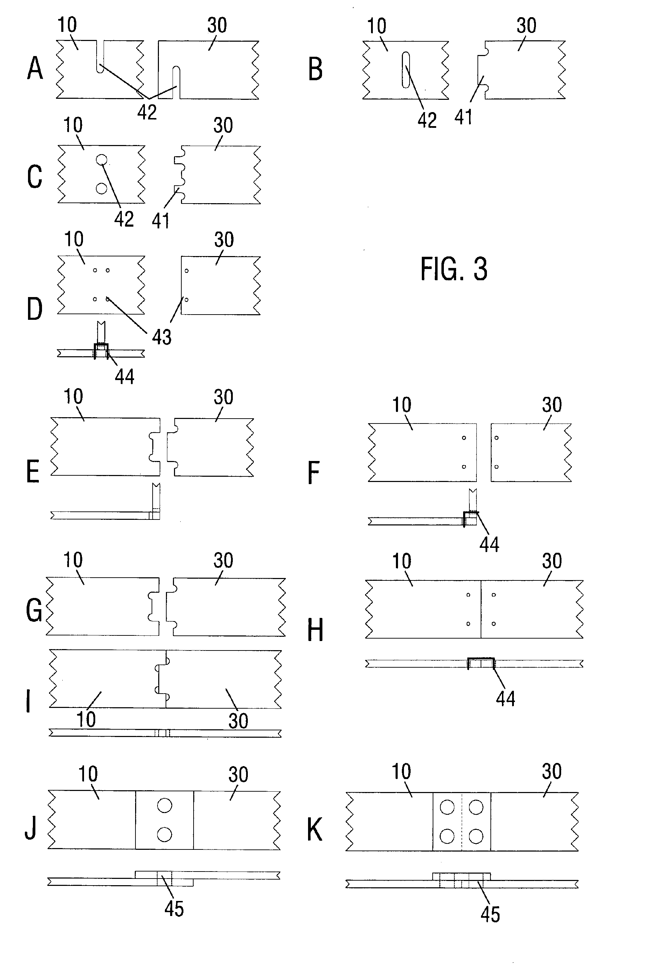

While Figures 1 and 2 show screw connections between the PCBs, other types of connections can be used as schematically illustrated in Figures 3A to 3K. Figures 3A to 3C illustrate examples of plane to edge connections, wherein a surface section of one of the PCBs, e.g. 10, to an edge section of the other PCB, e.g. 30. Connectors of the connected boards comprise e.g. a pair of slits 42 (Figure 3A), a pair of a slit 42 and a tab 41 (Figure 3B) or pairs of holes 43 and tabs 41 (Figure 3C). Another example of a plane to edge connection is shown in Figure 3D, wherein a first PCB, e.g. 10 and a second PCB, e.g. 30 are connected using a bended rod 44, which is fixed in holes 43 in the carrier boards 10, 30.

Examples of edge to edge connections are illustrated in Figures 3E to 3K, wherein Figures 3E and 3F show edge to edge connections of PCBs perpendicular to each other and Figures 3G to 3K show edge to edge connections of PCBs arranged in one common plane. The edge to edge connection can be implemented by connectors adapted for a mutual engagement, like tab-slit-combinations (Figures 3E, 3G and 3I). Alternatively, bended rods or wires 44 or connecting sticks 45 (Figures 3F, 3H, 3J and 3K) can be used.

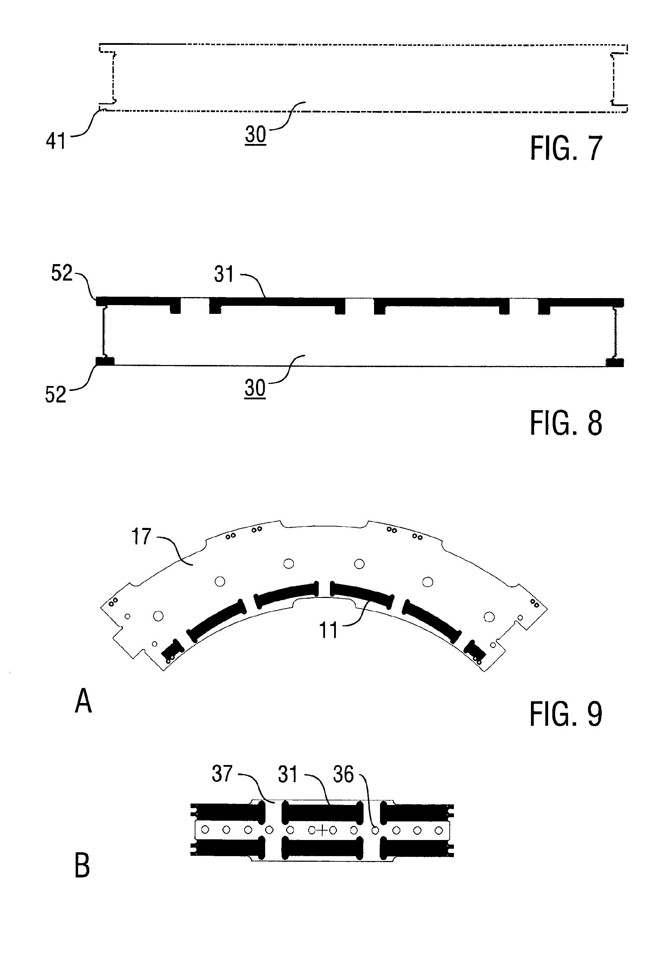

The above types of connectors can be used for connecting the carrier boards or for connecting board sections of the carrier boards (see Figure 9).

Figures 4A to 4C illustrate variants of through-holes 16 formed for stray capacitance reduction in a section of a carrier board 10. With the illustrated examples, the through-hole 16 may comprise a slit connected to the border of the board (Figure 4A), a slit formed in the plate material of the board (Figure 4B) or one or more holes (Figure 4C). Preferably, the through-hole(s) 16 is/are arranged between the ends of coil segments 11 which face to each other and which can be connected e. g. via capacitors, e.g. for tuning purposes. Alternatively or additionally, the through-holes 16 can be arranged in a longitudinal direction between adjacent, e.g. parallel coil segments (see e.g. Figure 9B). Additionally or as a further alternative option, through-holes can be arranged in a section of a coil segment as illustrated in Figure 4C. With the milled slits or drilled holes, stray capacitances between the adjacent copper traces and dielectric losses can be reduced, which otherwise would be introduced by non-ideal dielectric properties of the board material.

In a practical example, a common printed circuit board base material, e.g. FR4, can be used which has good mechanical properties, but may exhibit dielectric losses, especially at higher frequencies (3T and above). Without a slit, the two T-shaped copper areas facing to each other (Figure 4A) would work as a lossy capacitor, e.g. about 1 pF. With a capacitor of 30 pf soldered on the ends (for a coil for low field MRI), the resulting 31 pF still could be acceptable. However, with a 3 p capacitor (for a coil for high field MRI), the resulting 4 pF would be noticeable lossy. With the slit 16 (or a row of holes) between the landing pads, the stray capacitance is smaller and the losses too. As an example, lossy 1 pF could be reduced to 0.5 pF resulting in much less losses.

A second embodiment of the inventive coil arrangement 100 and details thereof are illustrated in Figures 5 to 8. The coil arrangement 100 is a 4-element cylindrical array for magnetic resonance imaging of the human head. The presented implementation is made of two ring structures and that are connected by eight linear pieces. Mechanical, non-circuit board elements with connectors can also serve to enhance the rigidity of the final structure.

Figure 5 shows a schematic perspective view of the coil arrangement 100 comprising 10 plane carrier boards with a first main board 10, a second main board 20 and a plurality of secondary boards 30. The carrier boards 10, 20 and 30 are arranged for enclosing a cylindrical space 2 under investigation, e.g. for medical imaging purposes. Each of the main boards 10, 20 has a ring shape as illustrated in Figure 6. On outer surfaces of the main boards 10, 20, coil segments 11, 21, electrical connections and optionally further electronic components are provided, while on the inner surfaces (facing to the sample space 2), further coil segments can be provided (not shown in Figure 6). The ring shape forms a recess 12, 22, through which a sample, like a patient's head can be introduced into the coil arrangement 100. The secondary boards 30 are plane rectangular boards, which are arranged between the main boards 10, 20. The secondary boards 30 extend parallel to an axial direction of the cylindrical sample space 2. Pairs of two secondary boards 30 are distributed along the circumference of the ring-shaped main boards 10, 20 (see Figure 5).

The carrier boards 10, 20 and 30 are connected via connectors, which comprise tabs 41 at the longitudinal ends of the secondary boards 30 (see Figure 7) and slits 42 in the main boards 10, 20 (see Figure 6). The slits 42 are sufficiently tight (e.g. 2.2 mm) so that the tabs 41 can be introduced into the slits 42 in a force fitting fashion. Accordingly, the structure does not require additional mechanical support or adhesives. However, optionally an adhesive can be added to the slits 42 and if necessary along the edge of the secondary board 30 between the tabs 41.

Figure 8 schematically illustrates a secondary board 30 carrying coil segments 31 and optionally further electronic components (not shown). The electrical connections between the coil segments 31 and the main boards 10, 20 are obtained by providing the tabs with a metallic layer 52, like e.g. a Cu or an Ag layer. Accordingly, the tabs can be used for both of mechanical and electrical connections.

The carrier boards used according to the invention can be divided into board sections 17. A ring-shaped board can consist of board sections 17 (see Figure 9A) each made of a PCB carrying at least one coil segment 11. The board sections 17 are connected to each other with mechanical connectors, which can be shaped as described above, e.g. by projections and recesses being connected by a mutual engagement (see Figure 3). The electrical connections between the board sections 17 can be obtained by wire connections or by direct soldering of coil segments 11. The rectangular secondary boards 30 can be divided into board sections 37, as well (see Figure 9B). Again, the board sections 37 are connected to each other by suitable mechanical and electrical connectors. Furthermore, Figure 9B illustrates in an exemplary fashion that through-holes 36 can be arranged between adjacent parallel coil segments 31.

In a practical embodiment, the embodiment of Figure 5 was implemented as follows. The coil arrangement 100 is made of 2-mm-thick FR4 printed circuit boards (two rings 10 and 20 and 8 150-mm-long straight pieces 30) that fit together to assemble the 3-dimensional structure. The coil arrangement 100 comprises 4 rectangular loops, 85-degrees in width (222.5 mm) and 150 mm in length. 5-mm wide copper traces are perpendicular to the cylindrical surface of the sample space 2 inside the array. Each of the secondary boards 30 contains 16 breaks and 2 pin-diodes (MA4P2000, M/A-COM Technology Solutions, Lowell, Massachusetts, USA) that each activate a parallel resonant inductance. Each resonant trap contains 2 inductors in parallel (1812SMS-22NGLB, Coil Craft, Wardpark North Cumbernauld, Scotland, UK) that are activated during receive mode to detune the coil. Chokes (132-19SMGLB, Coil Craft, Wardpark North Cumbernauld, Scotland, UK) on the DC bias lines prevent interaction of the lines with the coil RF signals. Each element is tuned and matched with a classic parallel-tune, balanced series-match configuration, and fed with a wire-wound balun built by removing the outer insulation of RG-233 coax cable (shielded with a 25-mm-diameter cylindrical fabric shield), and built around a PCB that connects to the main board 10. An additional cable-trap is built with the same design 12 cm away from the cable-trap feed balun. Instead of inductive or capacitive decoupling, minimum-reflected-power tuning was used as described by M. B. Kozlov et al. in "J. of Magn. Reson." 2009, 200 (1):147-152.

For test measurements, a 180-mm-diameter phantom was used to load the coil (7.3 L with 1.24g/L NiSO4 x 6H20 and 2.62 g/L NaCl; T1 300ms, 0.52 S/m, rel. permittivity 78). A shielding fabric (50 dB EMC screening fabric Aaronia-Shield, Aaronia AG, Euscheid Germany) was used, which is a polyimide weave with a silver coating. Data from a hand-built array were compared to a coil arrangement according to the present invention. Both arrays are for transmitting the magnetic resonance excitation pulse. Layout of the copper traces by hand took multiple days, and the result was an array that varied by millimeters in the element-to-element spacing. Fabrication of an identical array would take equally long, and would result in errors approaching the cm scale. On the other hand, laying out the coil arrangement according to the present invention in circuit layout software allows an unlimited number of identical arrays with sub-millimeter precision to be assembled from batchfabricated pieces. Scripts for circuit layout allow for quick modification of array parameters, including diameter, trace width, element height, coil-to-coil gap, number of breaks per element, distance to the shield, and the design of sub-circuits. The mechanical strength of the coil arrangement according to the present invention is sufficiently sturdy to make the use of acrylic cylinders as formers dispensable or optional. The coil arrangement according to the present invention was fabricated with a higher level of accuracy than the hand built array, and is therefore more symmetric. The loaded Q values of the elements vary more widely for the hand built array (8%), which has a coefficient of variation that is 4-times greater than that of the inventive coil arrangement (2%). Likewise, the variation of the coupling coefficient as estimated by peak-splitting, is greater for the hand fabricated coil (6% vs 2%). The effective loaded-resistance is similar for the two arrays and is not discernable by the estimates based on the Q measurements. The reflected power of both arrays was less than 1% (0.7% hand built; 0.2% PCB). The maps of the transmit field also indicated that the performance of the inventive coil arrangement is more symmetric, with peak transmit efficiency near individual elements varying by 10% for the hand-built coil and 0% for elements of the inventive PCB array.

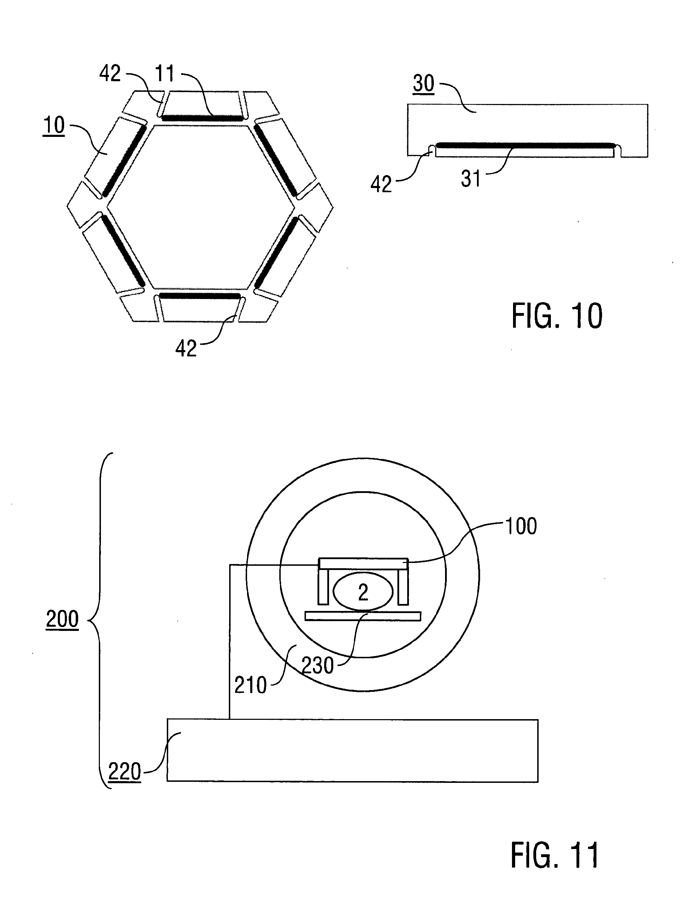

Figure 10 shows another embodiment of the invention, wherein the main board 10 has a polygon shape (Figure 10A) and the secondary boards 30 (Figure 10B) have a rectangular shape. Both boards 10, 30 carry coil segments 11, 31. The connectors of the boards 10, 30 comprise slits 42 at the outer borders of the boards 10, 30. Accordingly, the three-dimensional structure of coil segments 11, 31 can be formed by connecting the two main boards 10 with twelve secondary boards 30 via the slits 42. As the coil segments 11, 31 terminate at the ends of the slits 42, electrical connections can be provided by direct soldering or additional wire connections.

Figure 11 schematically illustrates an embodiment of an MRI apparatus 200 comprising a main magnetic field device 210 and in particular a coil arrangement 100 according to the invention. Additionally, a control device 220 and a support 230 carrying the sample 1 to be investigated are provided. With the invention, the coil arrangement 100 is adapted to be arranged in the main magnetic field device 210. The direction of the static magnetic field of the MRI apparatus 200 is the axial direction. Preferably, one or both of the largest carrier boards (main boards) are arranged perpendicular to the axial direction, while the other carrier boards (secondary boards connecting the main boards) are arranged parallel to the axial direction.

The features of the invention disclosed in the above description, the figures and the claims can be equally significant for realizing the invention in its different embodiments, either individually or in combination.

## Claims

1. Coil arrangement (100), being adapted for magnetic resonance imaging of a sample (1) in a sample space (2) under investigation, comprising:
- a plurality of carrier boards (10, 20, 30) being made of printed circuit boards and carrying a plurality of coil segments (11),
**characterized in that**
- the carrier boards (10, 20, 30) are mechanically connected with each other so that a three-dimensional arrangement of coil segments (11) is formed.

2. Coil arrangement according to claim 1, wherein the carrier boards (10, 20, 30) comprise
- two main boards (10, 20) having a predetermined mutual distance, and
- a plurality of secondary boards (30), wherein the main boards (10, 20) are connected by the secondary boards (30) so that the main and secondary boards (10, 20, 30) are arranged adjacent to the sample space (2).

3. Coil arrangement according to one of the preceding claims, wherein
- at least one of the carrier boards (10, 20) includes a recess (12, 22) being arranged for accessing to the sample (1) in the sample space (2), and
- a cover board (13, 23) carrying coil segments (11, 21) is removably arranged across the recess (12, 22).

4. Coil arrangement according to one of the preceding claims, wherein
- at least one of the carrier boards (10, 20, 30) has a ring, ring-like structure, elliptical or polygon shape defining the recess (12, 22).

5. Coil arrangement according to one of the preceding claims, wherein
- at least one of the carrier boards (10, 20, 30) includes at least one through-hole (16, 26, 36) being arranged for at least one of venting and reducing stray capacitances, and/or
- at least one of the carrier boards (10, 20, 30) comprises at least two board sections (17, 37) made of printed circuit boards connected to each other.

6. Coil arrangement according to claim 5, wherein
- the at least one through-hole (16, 26, 36) is arranged between ends of coil segments (11, 21, 31) facing to each other and/or between adjacent coil segments (11, 21, 31).

7. Coil arrangement according to one of the preceding claims, wherein
- the carrier boards (10, 20, 30) are connected with each other through a plurality of connectors.

8. Coil arrangement according to claim 7, wherein
- the connectors comprise at least one of plane to edge connectors and edge to edge connectors, and/or
- the connectors are detachable.

9. Coil arrangement according to claim 7 or 8, wherein
- the connectors comprise pairs of tabs (41) and slits (42) each provided by one of the carrier boards connected with each other.

10. Coil arrangement according to one of the preceding claims, wherein
- at least one electrical connection is provided between the carrier boards (10, 20, 30) connected with each other.

11. Coil arrangement according to claim 10, wherein the at least one electrical connection is provided by at least one of
- non-magnetic screws (51), e. g. made of brass, connecting the carrier boards with each other, and
- strip conductors (52) provided on the carrier boards connected with each other.

12. Coil arrangement according to one of the preceding claims, wherein
- the coil segments are arranged in a self-supporting fashion without an additional support structure, and/or
- the coil segments form a Helmholtz coil arrangement, surface coil arrays or a birdcage coil arrangement.

13. Magnetic resonance imaging apparatus (200) comprising a coil arrangement according to any of the preceding claims.

14. Method of manufacturing a coil arrangement (100) according to one of the preceding claims, comprising the steps of:
- providing the carrier boards (10, 20, 30) carrying the coil segments (11, 21, 31), and
- connecting the carrier boards (10, 20, 30) so that the three-dimensional arrangement of coil segments (11, 21, 31) is created.

15. Use of a coil arrangement (100) according to any of the claims 1 to 12 for transmitting and/or receiving radiofrequency signals in a magnetic resonance imaging apparatus (200).
